Europäisches Patentamt

European Patent Office

Office européen des brevets

(19)

(11) Numéro de publication: **0 228 953**
**B1**

(12) **FASCICULE DE BREVET EUROPEEN**

(45) Date de publication du fascicule du brevet:
10.10.90

(51) Int. Cl.⁵: **H01L 23/04**, H01L 25/04, H01L 23/58

(21) Numéro de dépôt: 86402788.3

(22) Date de dépôt: 12.12.86

(54) Boîtier d'encapsulation d'un circuit électronique.

(30) Priorité: 17.12.85 FR 8518695

(43) Date de publication de la demande:
15.07.87 Bulletin 87/29

(45) Mention de la délivrance du brevet:
10.10.90 Bulletin 90/41

(84) Etats contractants désignés:
DE GB IT NL

(56) Documents cités:
EP-A- 0 042 987
EP-A- 0 154 998
FR-A- 2 555 812
FR-A- 2 565 032

IBM TECHNICAL DISCLOSURE BULLETIN,
vol. 23, no. 1, juin 1980, pages 374-377, New York, US;
E.F. MIERSCH et al.: "High speed metal carrier packaging system using thin-film interconnection techniques"
INTERNATIONAL JOURNAL FOR HYBRID MICRO-ELECTRONICS,
vol. 7, no. 2, juin 1984, pages 21-34, The International Society for Hybrid Micro-electroics, Silver Spring, Maryland, US; C.M. VAL: "Trends in packaging"
IBM TECHNICAL DISCLOSURE BULLETIN,

(73) Titulaire: THOMSON-CSF, 51, Esplanade du Général de Gaulle, F-92800 Puteaux(FR)

(72) Inventeur: Val, Christian, Thomson-CSF SCPI 19, avenue de Messine, F-75008 Paris(FR)

(74) Mandataire: Turlèque, Clotilde et al, THOMSON-CSF SCPI, F-92045 PARIS LA DEFENSE CEDEX 67(FR)

(56) Documents cités: (suite)
vol. 21, no. 10, mars 1979, pages 4023-4024, New York, US; B. MARTIN et al.: "Hermetic hybrid module"

## Description

La présente invention a pour objet un boîtier d'encapsulation contenant circuit électronique, le boîtier étant plus particulièrement destiné à un circuit électronique de grande taille, réalisé en technologie hybride ou intégrée sur substrat semi-conducteur.

On sait que lorsque la taille d'un circuit électronique augmente, la longueur du parcours des tensions d'alimentation dans le semi-conducteur, dans le cas par exemple d'un circuit électronique intégré, augmente également. Cette augmentation a différents effets néfastes :
- avec la longueur du trajet augmente la résistance électrique, ce qui augmente les pertes ohmiques ; au bout d'une certaine longueur, la tension d'alimentation peut devenir trop faible pour un fonctionnement normal du circuit intégré ;
- avec la longueur du trajet augmente également l'inductance ; cela provoque des retards dans les signaux qui sont fonction de la longueur du parcours de ces signaux et qui, lorsque certains des parcours deviennent grands, peuvent ne plus être négligeables devant, par exemple, la période d'une horloge dans un circuit numérique ;
- l'augmentation de l'inductance provoque également des tensions parasites selon la formule $\Delta V = L.di/dt$ ; ces tensions parasites peuvent devenir, dans certain cas, égales ou supérieures à l'immunité aux bruits du circuit, c'est-à-dire la différence entre le seuil de basculement et le "0" ou le "1" logique.

Pour diminuer ces effets, une solution consiste à alimenter le circuit intégré en de nombreux points répartis sur sa surface, et non plus seulement à sa périphérie. Toutefois, pour que cette solution soit efficace, il faut que les voies d'amenée de l'alimentation aient à la fois une résistance et une inductance inférieures à celles du semi-conducteur, afin de ne pas présenter les inconvénients précédents. Or cette condition peut n'être pas remplie dans le cas où ces connexions sont réalisées classiquement par fil sur une grande longueur.

Lorsque le circuit électronique est réalisé en technologie hybride, les mêmes types de difficultés apparaissent lorsque le circuit devient grand.

Ceci constitue donc une limite aux dimensions d'un circuit électronique.

Le FR-A 2 565 032 décrit un boîtier d'encapsulation d'un circuit électronique, comportant une embase sur laquelle est disposé le circuit et un capot assurant la fermeture du boîtier, le circuit comortant une pluralité de plots auxquels doivent être amenées les tensions nécessaires à son alimentation, répartis à la périphérie du circuit les voies d'amenées de ces tensions d'alimentation, entre les plots de connexion du boîtier et ceux du circuit, comportant chacune au moins un plan conducteur, les différents plans étant placés en couches superposées, sans contact électrique les unes avec les autres, dans le capot.

La présente invention a donc pour objet de réduire les limitations mentionnées précédemment d'une part en minimisant le parcours des tensions d'alimentation dans le circuit électronique lui-même, ce qui est réalisé en amenant les tensions d'alimentation en différents points répartis sur la surface du circuit électronique autour d'ouverture qui sont pratiquées dans le circuit, et d'autre part en utilisant comme voies d'amenée des tensions d'alimentation des plans conducteurs, placés en couches superposées dans le capot et ou l'embase du boîtier d'encapsulation du circuit électronique considéré.

Plus précisément, l'invention a pour objet un boîtier d'encapsulation tel que défini par la revendication 1.

D'autres objets, particularités et résultats de l'invention ressortiront de la description suivante, donnée à titre d'exemple non limitatif et illustrée par les dessins annexés, qui représentent :

- les figures 1, a et b, un premier mode de réalisation du boîtier selon l'invention pour l'encapsulation d'un circuit intégré, vu respectivement en coupe et de dessus ;
- la figure 2, une variante d'une partie du boîtier de la figure précédente, comportant un condensateur ;
- la figure 3, une variante de connexion des voies d'amenée de l'alimentation au circuit électronique, lorsque celles-ci sont portées par le capot du boîtier ;
- la figure 4, un deuxième mode de réalisation du boîtier selon l'invention ;
- les figures 5, a et b, un troisième mode de réalisation du boîtier selon l'invention, respectivement vu en coupe et vu de dessus ;
- les figures 6, a et b, un mode de réalisation de la connexion du boîtier selon l'invention, respectivement vu en coupe et de dessus ;
- les figures 7, a et b, deux variantes de réalisation d'un boîtier selon l'invention encapsulant deux circuits électroniques ;
- les figures 8, a et b, un mode de réalisation du boîtier selon l'invention pour l'encapsulation de circuits hybrides, respectivement vu en coupe et de dessus ;
- les figures 9, a et b, deux variantes de réalisation d'un boîtier selon l'invention encapsulant deux circuits hybrides.

Sur ces différentes figures, les mêmes références se rapportent aux mêmes éléments. Par ailleurs, pour la clarté du dessin, l'échelle réelle n'a pas été respectée.

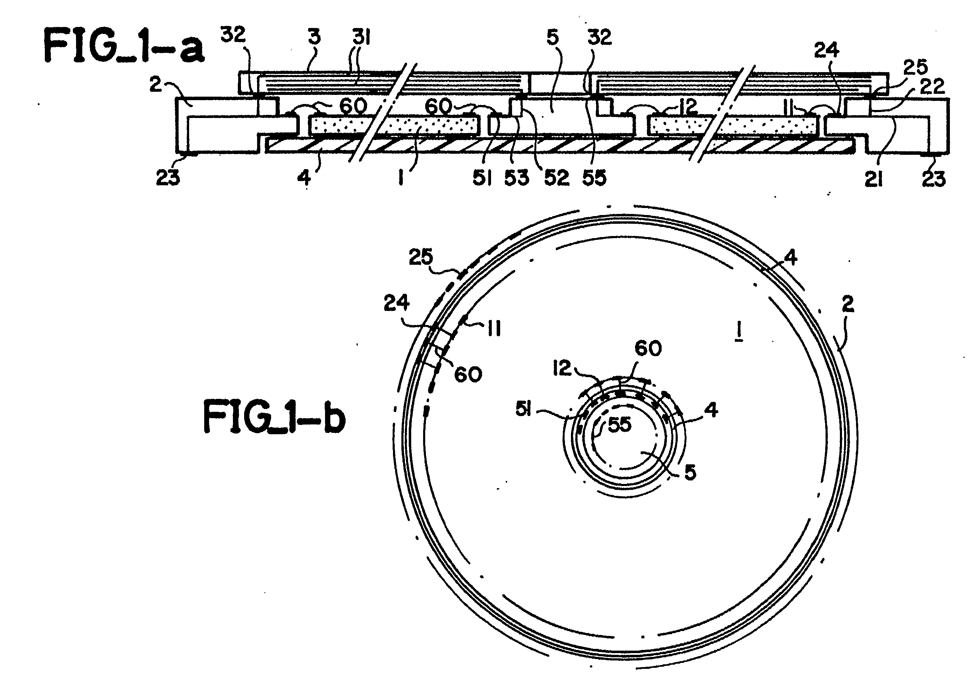

Sur les figures 1, on a donc représenté un premier mode de réalisation du boîtier selon l'invention, vu en coupe sur la figure 1a et vu de dessus sur la figure 1b.

Le boîtier selon l'invention est donc destiné à l'encapsulation d'un circuit électronique de grande taille ; sur les figures 1, ce circuit électronique est par exemple une rondelle (également appelée "wafer" dans la littérature anglo-saxonne) de matériau semi-conducteur dans laquelle est réalisé un circuit électronique. Cette rondelle peut avoir typiquement une taille de l'ordre de quelques centimètres, par exemple de 1 à 10 cm. Dans le mode de réalisation de la figure 1, le circuit est réalisé de sorte que la rondelle puisse présenter une ouverture centrale. Des plots de connexion du circuit, repérés 11, sont répartis à la périphérie de la rondelle 1 ; d'autres plots, repérés 12, sont répartis à la périphérie de l'ouverture centrale.

Le boîtier selon l'invention pour l'encapsulation de cette rondelle 1 comporte, dans ce mode de réalisation, un fond repéré 4, une partie périphérique 2 en forme d'anneau formant avec le fond 4 une embase, un pilier central 5 et un capot 3. Le pilier 5 est placé au centre du fond 4, sur ce dernier et la rondelle semi-conductrice 1 est placée sur le fond 4 de sorte que le pilier 5 émerge de son ouverture centrale. L'anneau 2 est placée à la périphérie du fond 4. Le capot 3, qui comporte également une ouverture centrale mais de plus petit diamètre que le pilier 5, repose à la fois sur l'anneau périphérique 2 et sur le pilier 5.

A titre d'exemple, l'anneau 2, le pilier 5 et le capot 3 peuvent être en alumine. Le fond 4 peut être également en alumine ou en métal ou encore en un matériau éventuellement composite, présentant une bonne conduction thermique afin de faciliter le refroidissement de la rondelle 1. Lorsque les trois éléments 2, 4 et 5 sont en alumine, le pilier 5 et l'anneau 2 sont de préférence frittés sur le fond 4. Lorsque le fond 4 est métallique, les éléments 2 et 5 sont de préférence brasés sur ce dernier, à l'aide d'une brasure argent-cuivre par exemple.

La rondelle semi-conductrice 1 est fixée classiquement sur le fond 4. Elle est connectée, d'une part, par ses plots 12 et des fils de connexion 60 à un premier niveau de connexion du pilier 5, portant des plots 51. Elle est d'autre part connectée (plots 11) à un premier niveau de connexion de l'anneau périphérique 2, portant des plots 24. Ces plots 24 de l'anneau 2 sont reliés, par des pistes 21 et des trous métallisés (ou puits métalliques) 22 formés classiquement, d'une part à des plots 23 de connexion du boîtier à l'extérieur et d'autre part à des plots 25 situés sur un deuxième niveau de connexion de l'anneau 2 et destinés à transmettre au capot 3 les tensions d'alimentation reçues sur les plots 23.

Dans ce mode de réalisation, c'est le capot 3 qui remplit la fonction supplémentaire selon l'invention de distribution des tensions d'alimentation 4 au centre de la rondelle semi-conductrice 1, par l'intermédiaire du pilier 5. A cet effet, le capot 3 comporte une pluralité de plans 31, conducteurs, parallèles et isolés les uns des autres, amenant chacun une tension d'alimentation ou la masse vers le pilier central 5. Le capot 3 comporte sur sa face inférieure des plots de connexion 32 qui viennent au contact des plots de connexion 25 de l'anneau 2 et des plots 55 du pilier 5, situés sur un deuxième niveau de connexion, dont ils ne se distinguent pas sur la figure. Les plots 55 du pilier 5 sont reliés aux plots 51 de ce même pilier, classiquement par l'intermédiaire de trous métallisés (ou puits métalliques) 52 et de pistes 53.

Ainsi, selon l'invention, les tensions d'alimentation reçues par le boîtier sur les plots 23 sont fournies au circuit électronique réalisé dans la rondelle 1, d'une part, par les plots périphériques (11) de cette rondelle et, d'autre part, par les plots centraux (12) de cette dernière. De la sorte, la distance parcourue dans la rondelle semi-conductrice par les tensions d'alimentation est au maximum d'un demi-rayon (en négligeant la dimension de l'ouverture centrale de la rondelle) au lieu d'être d'un rayon entier lorsque le circuit n'est alimenté que périphériquement.

Les signaux autres que les tensions d'alimentation sont reliés de préférence aux plots périphériques (11) de la rondelle.

De plus, afin de réduire la résistance et l'impédance du trajet des tensions d'alimentation, celles-ci sont véhiculées par des plans conducteurs. En effet, en ce qui concerne la résistance des connexions, on sait qu'elle est inversement proportionnelle à la section du conducteur formant la connexion ; si cette section est rectangulaire et si une des dimensions est donnée (l'épaisseur du conducteur par exemple), on voit que cette résistance est d'autant plus faible que le conducteur est plus large ; il en ressort qu'un plan, comme utilisé dans la présente invention, présente une résistance inférieure à un conducteur filaire ou une piste conductrice, à épaisseur et matériau donnés ; en outre, le matériau constituant les plans conducteurs est choisi parmi ceux qui présentent une faible résistivité.

En ce qui concerne l'impédance présentée par les connexions, il apparaît que l'impédance d'une plaque est inférieure à celle d'un fil, pour une longueur de trajet et un matériau donnés. On a en effet pour un fil :

$$L_f = 2. \ell \, Log \left( \frac{4\ell}{d} \right) - \frac{3}{4}$$

où :
- $L_f$ est l'inductance du fil en nH ;
- $\ell$ est la longueur du fil en cm ;
- d est le diamètre du fil en cm ;
- Log est le symbole des logarithmes népériens.

Pour $\ell = 1$ cm et d = 50 μm, on obtient $L_f = 11,87$ nH. Pour une plaque, l'expression de son inductance $L_p$ est :

$$L_p = 2.L \, Log \left( \frac{2.L}{\ell} \right) + 0,5$$

où L et $\ell$ sont respectivement la largeur et la longueur de la plaque en cm. Pour $L=\ell=1$ cm, on obtient $L_p = 2,386$ nH, ce qui est une valeur très inférieure à la valeur de $L_f$.

Il est à noter par ailleurs qu'une même tension d'alimentation peut être véhiculée par plusieurs plans tels que 31 : cela permet de s'affranchir des effets de limitations d'ordre technologique à l'augmentation de l'épaisseur des plans.

La présence de plans conducteurs (31) dans le capot 3 forme en outre des capacités qui peuvent avantageusement remplir les fonctions habituellement réalisées par des condensateurs auxiliaires disposés autour du boîtier ou même sur ce dernier, comme le découplage par exemple.

Dans le boîtier selon l'invention, le pilier central 5 remplit encore une autre fonction : celle de support mécanique du capot 3. En effet, lorsque les dimensions du boîtier deviennent grandes, il s'exerce des forces importantes sur le capot lors du scellement du boîtier et durant le fonctionnement du dispositif (cycles de pression-dépression dus aux différences de température et d'altitude) ; ces efforts sur le capot posent des problèmes de résistance mécanique de celui-ci, que l'existance du pilier central permet de résoudre simplement, sans augmentation notable de son épaisseur.

Enfin, les matériaux constituant les plans conducteurs 31 et le capot 3 peuvent être choisis afin de protéger ("durcir") le boîtier des radiations, par exemple selon la technique décrite dans le brevet FR-A 2 547 113 au nom de CIMSA.

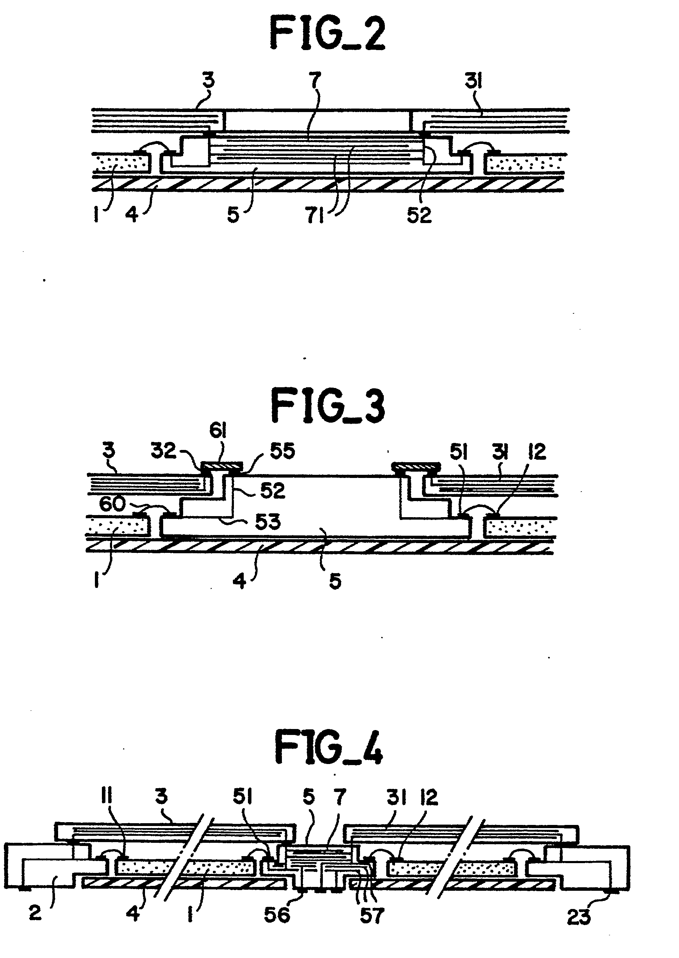

La figure 2 représente une variante de réalisation de la figure précédente, dans laquelle le pilier central 5 comporte en outre un condensateur.

La figure 2 est une vue partielle de la figure 1a, vue sur laquelle on retrouve le pilier 5 et, partiellement, le fond 4, la rondelle semi-conductrice 1 et le capot 3 avec ses plans conducteurs 31.

Dans cette variante, le pilier central comporte en outre un condensateur 7, constitué par une pluralité de plans 71, conducteurs, parallèles et isolés les uns des autres, formant les armatures du condensateur et connectés par exemple entre les trous métallisés 52, le matériau constituant le pilier 5 formant le diélectrique du condensateur.

La figure 3 représente une autre variante du dispositif de la figure 1a, portant sur le mode de connexion du capot 3 au pilier central 5.

Sur cette figure on retrouve, partiellement, la rondelle semi-conductrice 1, le fond 4 et le capot 3, disposés autour du pilier 5.

Toutefois, le pilier 5 ne comporte plus deux mais trois niveaux : le premier niveau porte toujours les plots de connexion 51 reliés à la rondelle 1 ; les plots de connexion 55 destinés à être reliés au capot 3 sont maintenant portés par un troisième niveau, supérieur ; le capot 3 est supporté mécaniquement par un deuxième niveau, intermédiaire, du pilier 5. Les plots de connexion 32 du capot 3 sont portés maintenant par sa face supérieure et la connexion entre les plots 32 et les plots 55 est assurée à l'aide par exemple de barrettes 61, ou de fils, rubans, etc.

Bien entendu, ce mode de connexion s'applique également à la connexion du capot 3 avec l'anneau périphérique 2 de la figure 1a.

Les avantages de cette variante sont de permettre, principalement, au boîtier d'être plat, ce qui facilite sa mise en oeuvre, et de séparer l'opération de scellement du capot sur le pilier 5 et l'anneau 2 de celle de connexion électrique des plots 32 avec les plots 55 et 25, ce qui en facilite la réalisation. En effet, dans le mode de réalisation illustré sur les figures 1, scellement et connexion doivent être réalisés simultanément.

La figure 4 représente un autre mode de réalisation du dispositif selon l'invention, dans lequel l'alimentation est fournie au boîtier par le pilier central.

Sur cette figure, on retrouve le pilier central 5, l'anneau périphérique 2, le fond 4, le capot 3 et la rondelle semi-conductrice 1.

Comme précédemment, l'anneau 2 est muni de plots 23 pour la connexion du boîtier vers l'extérieur et il est relié aux plots 11 de la rondelle semi-conductrice. Toutefois, dans ce mode de réalisation, le fond 4 comporte une ouverture centrale de façon à laisser apparaître le pilier 5 qui est alors muni sur sa face inférieure de plots 56 de connexion du boîtier avec l'extérieur. Ces plots 56 reçoivent notamment les tensions d'alimentation de la rondelle 1. Ils sont reliés électriquement aux plots 11 de la rondelle 1 par l'intermédiaire de plans conducteurs 57, placés parallèlement les uns aux autres dans l'épaisseur du pilier 5. Le capot 3 est fixé sur la face supérieure de l'anneau 2 et du pilier 5 et connecté à ces derniers comme illustré par exemple sur la figure 1a. Les plans conducteurs 31 qu'il porte assurent l'amenée de l'alimentation aux plots 11 de la rondelle semi-conductrice 1. Le fond 4 est fixé mécaniquement, sans connexion électrique, par exemple sur un épaulement ménagé dans le pilier 5 et dans l'anneau 2.

Dans la variante représentée sur la figure 4, le pilier 5 comporte en outre un condensateur 7 réalisé dans la partie supérieure du pilier et analogue au condensateur 7 de la figure 2. les plans 57 sont alors localisés dans la partie inférieure du pilier 5.

Il est à noter que les plots 56, comme les autres plots (23) de connexion du boîtier vers l'extérieur, peuvent être munis de broches pour connexion ultérieure sur un substrat porteur du type circuit imprimé.

Dans un autre mode de réalisation, non représenté, les voies d'amenée des tensions d'alimentation sont constituées par des plans conducteurs disposés parallèlement les uns aux autres dans l'épaisseur du fond 4 du boîtier, de façon analogue à ce qui est illustré dans les figures précédentes pour les plans 31 du capot 3.

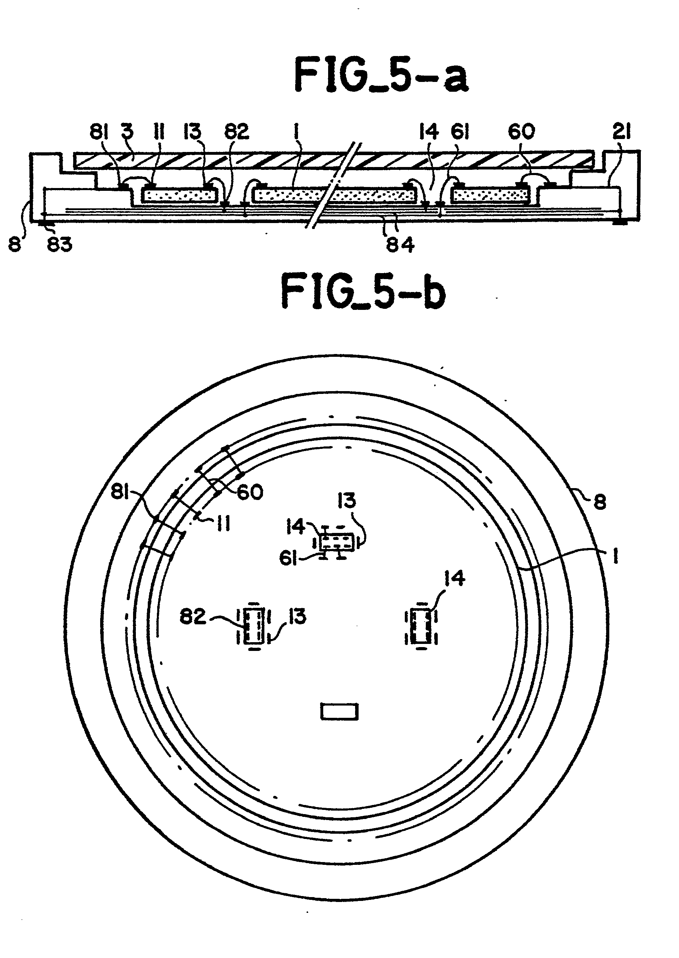

Les figures 5 représentent un autre mode de réalisation du dispositif selon l'invention, la figure 5a vu en coupe et la figure 5b vu de dessus. Dans ce mode de réalisation, la rondelle semi-conductrice 1 n'est plus percée d'une ouverture unique en son milieu mais d'une pluralité d'ouvertures, réparties sur sa surface.

Sur ces figures, on retrouve donc la rondelle 1 percée d'ouvertures 14 qui sont, dans cet exemple, sensiblement rectangulaires et réparties sensiblement sur un même cercle de rayon voisin de la moitié de celui de la rondelle. Dans ce mode de réalisation, l'anneau périphérique 2 du boîtier et son fond 4 tel que représentés dans les figures précédentes sont réunis en une même pièce 8 formant l'embase du boîtier, le capot 3 étant fixé sur un épaulement ménagé dans l'embase 8. La rondelle 1 est disposée dans le fond de l'embase 8 par tous moyens connus. Un deuxième épaulement de l'embase 8 porte des plots de connexion 81 et constitue un premier niveau de connexion entre les plots 11 disposés à la périphérie de la rondelle 1 et l'embase 8, connexion réalisée par fils (60). Sur la face supérieure du fond de l'embase sont disposés des plots de connexion 82, destinés à être reliés par fil (61) à des plots de connexion 13, disposés sur la rondelle 1 autour des ouvertures 14.

Selon l'invention, l'embase 8 comporte une pluralité de plans 84, parallèles, conducteurs et isolés les uns des autres, disposés dans le fond de l'embase et reliés d'une part aux plots 82 et d'autre part aux plots de connexion extérieure du boîtier, repérés 83 et disposés sur la face inférieure de l'embase 8.

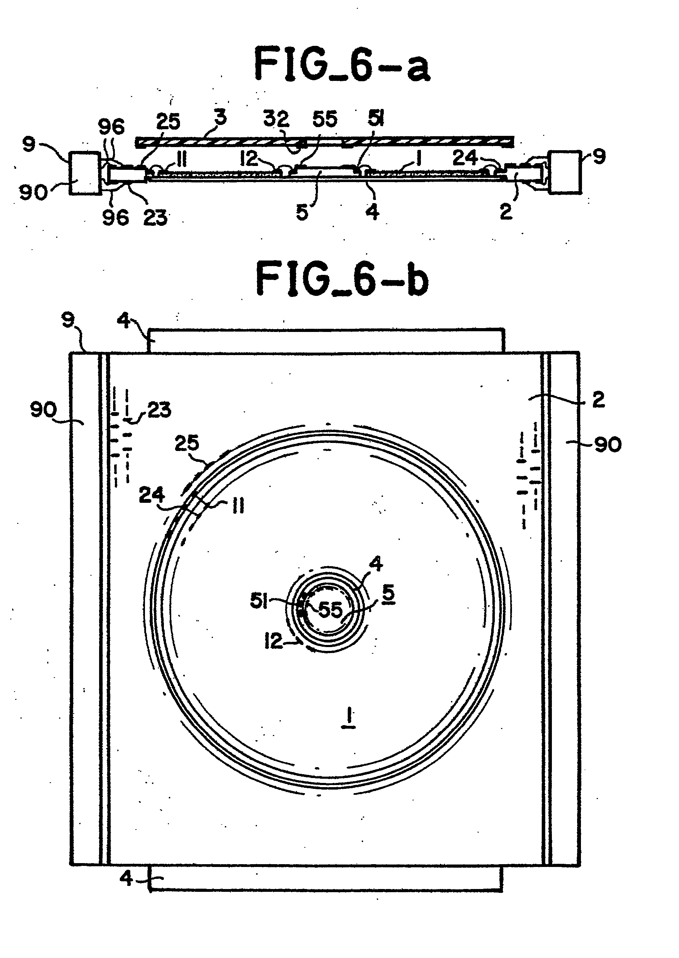

Les figures 6 représentent un mode de réalisation des connexions vers l'extérieur du boîtier selon l'invention dans le cas où ce dernier est, à titre d'exemple, réalisé comme décrit figure 1 ; la figure 6a montre une vue en coupe et la figure 6b une vue du même dispositif de dessus.

Pour clarifier le schéma, le capot 3 a été illustré sur la figure 6a distant de l'ensemble formé par la rondelle 1 et les éléments de boîtier 2, 4 et 5.

Les plots de connexion 23 portés par l'anneau 2, par exemple portés à la fois par les faces supérieure et inférieure de l'anneau, sont ici enserrés dans deux connecteurs de type U dont on a représenté sur la figure 6a les contacts 96 enserrés dans un bloc 90 ; sur la figure 6b, seul le bloc 90 a été représenté.

Par ailleurs, le dispositif est réalisé de telle sorte que le fond 4 du boîtier, lorsqu'il joue le rôle de drain thermique, dépasse du boîtier sur les côtés où ne sont pas prévus des connecteurs 9, comme représenté sur la figure 6b, de sorte à faciliter l'évacuation thermique.

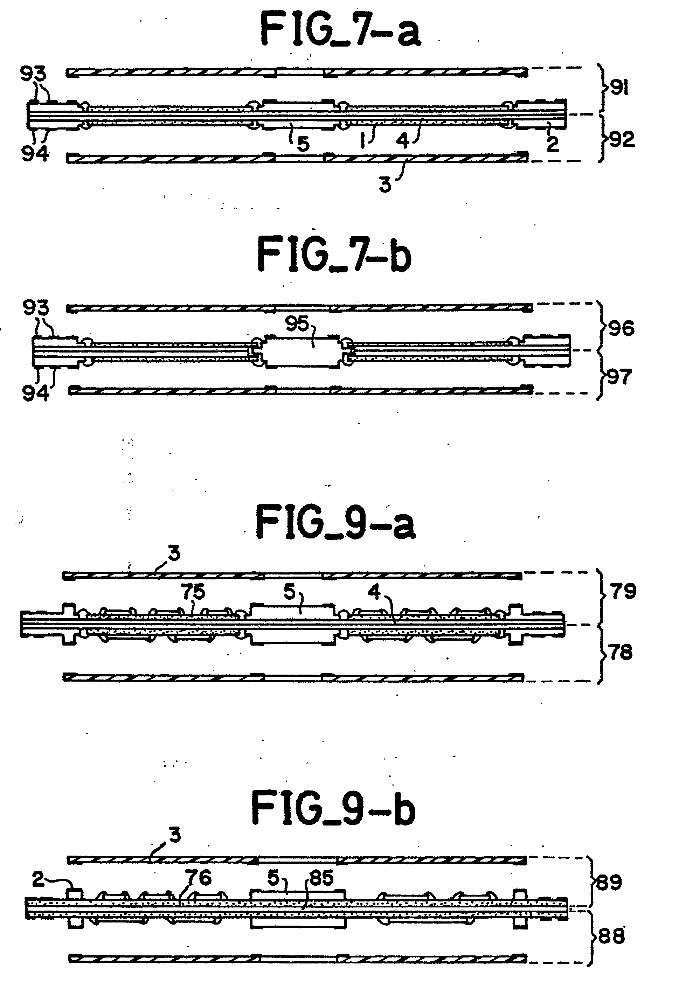

Les figures 7, a et b, représentent deux variantes du dispositif selon l'invention, portant chacune deux rondelles semi-conductrices.

Sur la figure 7a, on a représenté deux dispositifs par exemple tels que décrits figure 1a, repérés 91 et 92 et placés de sorte que leur fond 4 soit en contact l'un avec l'autre. Dans ce cas, les plots de connexion de chaque boîtier vers l'extérieur, repérés respectivement 93 et 94, sont placés sur la face extérieure (supérieure) de ceux-ci. Comme sur la figure 6a, les capots ont été représentés éloignés, pour la clarté du dessin.

Sur la figure 7b, les deux boîtiers concernés, repérés 96 et 97, sont du type de celui de la figure 4, ce qui permet de n'utiliser qu'un seul pilier central pour l'ensemble, repéré 95. De même dans ce cas, les plots de connexion de chaque boîtier vers l'extérieur sont placés sur les faces extérieures des boîtiers 96 et 97.

Dans une variante, non représentée, il est possible d'utiliser un seul fond (4), les rondelles étant alors disposées de part et d'autre de ce fond.

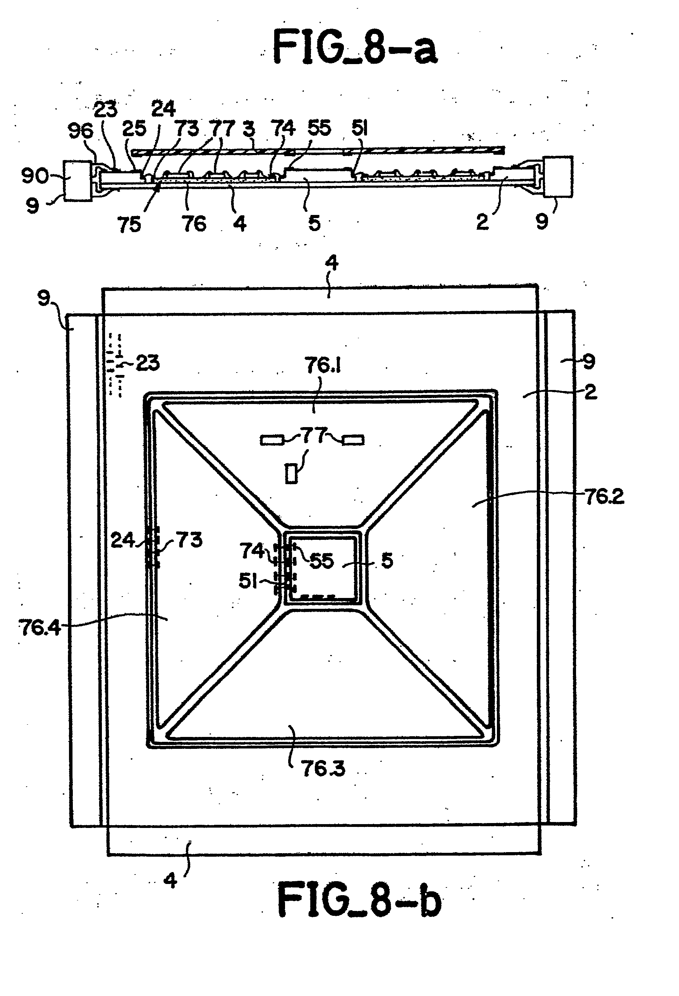

Les figures 8, a et b, représentent l'application du boîtier selon l'invention à l'encapsulation de circuit hybride. A titre d'exemple, le boîtier est représenté dans son mode de réalisation de la figure 1.

Sur la figure 8a, on retrouve donc le boîtier selon l'invention tel que représenté figure 1a, c'est-à-dire comportant un fond 4 fixé à un anneau périphérique 2 et à un pilier central 5, le tout étant fermé par un capot 3. Toutefois, la rondelle 1 de matériau semiconducteur est remplacée par un circuit hybride, repéré globalement 75 et comportant des composants 77, circuits discrets passifs ou actifs et circuits intégrés, disposés sur un substrat isolant 76. L'anneau périphérique 2 vient s'insérer par exemple dans deux connecteurs 9, en U, analogues à ceux des figures 6.

Sur la figure 8b on a représenté, vue de dessus, une variante de réalisation dans laquelle le substrat 76 du circuit hybride 75 est divisé en un certain nombre de parties, par exemple quatre, repérées 76-1, 76-2, 76-3 et 76-4. A titre d'exemple, quelques composants 77 ont été schématisés. A titre d'exemple encore, le fond 4 du boîtier fait saillie à l'extérieur comme illustré sur la figure 6b, pour les mêmes raisons.

Les alimentations, reçues par le boîtier sur les connecteurs 9, sont transmises au circuit hybride soit par ses plots périphériques, repérés 73, soit par ses plots centraux, repérés 74, via des plans conducteurs disposés, comme précédemment, dans le fond 4 ou dans le capot 3.

Ainsi, dans ce mode de réalisation comme dans le cas des circuits intégrés dans une rondelle de silicium, l'amenée de l'alimentation se fait par plans conducteurs en un certain nombre de points répartis sur la surface du circuit hybride 75 (au centre dans l'exemple des figures 8, mais qui peuvent être répartis autrement, comme illustré sur les figures 5 par exemple), et non comme précédemment par fil jusqu'à la périphérie du substrat du circuit hybride puis par piste conductrice déposée sur le substrat jusqu'au composant à alimenter. Les avantages qui en résultent, liés à la diminution de la résistance et de l'inductance, sont les mêmes que pour les circuits intégrés.

En outre, l'invention apporte, dans le cas des circuits hybrides, certains avantages supplémentaires, notamment :
- lorsqu'on accroit les dimensions des circuits hybrides, le rendement de fabrication diminue de façon très importante du fait qu'on accroit le nombre de composants et que ceux-ci sont difficilement testables en fréquence et en température ; le boîtier selon l'invention permet alors de fractionner un grand circuit en plusieurs petits circuits, comme illustré figure 8b, sans compliquer la connectique, les petits circuits étant alors portés par un même fond ;
- une difficulté importante dans la fabrication des circuits hybrides réside dans les entrées-sorties, généralement réalisées par des broches, isolées par verre dans le cas d'un boîtier métallique, et dont le nombre augmente avec la taille du circuit ; ces connexions sont remplacées dans le boîtier selon l'invention par des plots connectables au moyen d'un connecteur enfiché ou d'un connecteur à plat, ce qui simplifie grandement la fabrication.

Les figures 9 a et b, représentent deux variantes de réalisation, vues en coupe, de l'encapsulation selon l'invention de deux circuits hybrides.

Sur la figure 9a, on retrouve deux boîtiers, par exemple tels que décrits sur la figure 8a, repérés respectivement 78 et 79, fixés l'un à l'autre par leur fond 8.

La figure 9b représente une autre variante, dans laquelle le substrat isolant du circuit hybride, repéré 76, porte à la fois l'anneau périphérique 2 et le pilier central 5 du boîtier, celui-ci comportant comme précédemment un capot 3. Sur la figure 9b, on a disposé deux tels boîtiers, repérés 88 et 89, fixés respectivement sur chacune des faces d'un drain thermique repéré 85. L'ensemble forme un bloc rigide qu'on peut connecter électriquement à ses extrémités, par exemple par des connecteurs en U tels que décrits sur la figure précédente.

La description ci-dessus n'a bien entendu été faite qu'à titre d'exemple non limitatif. C'est ainsi, notamment, que les différentes variantes sont généralement cummulatives ; dans cet ordre d'idées, des plans conducteurs d'amenée de l'alimentation peuvent être placés à la fois dans l'embase et le capot du boîtier.

## Revendications

1. Boîtier d'encapsulation contenant un circuit électronique, le boîtier comportant une embase sur laquelle est disposé le circuit et un capot assurant la fermeture du boîtier, le circuit (1;75) comportant une pluralité de plots (11, 12; 73, 74) auxquels doivent être amenées les tensions nécessaires à son alimentation, répartis à la périphérie du circuit et autour d'au moins une ouverture percée dans ce dernier, et les voies d'amenées de ces tensions d'alimentation, entre les plots de connexion du boîtier et ceux du circuit, comportant chacune au moins un plan conducteur (31, 71, 57, 84), les différents plans étant placés en couches superposées, sans contact électrique les unes avec les autres, dans le capot (3) et/ou l'embase (2, 4 ;8).

2. Boîtier selon la revendication 1, caractérisé par le fait que lesdits plans forment en outre un condensateur.

3. Boîtier selon l'une des revendications précédentes, caractérisé par le fait que le circuit électronique est un circuit intégré (1).

4. Boîtier selon l'une des revendications précédentes, caractérisé par le fait que le circuit électronique est un circuit hybride (75).

5. Boîtier selon la revendication 4, caractérisé par le fait que le circuit hybride (75) est morcelé en une pluralité de parties (76.1 - 76.4).

6. Boîtier selon l'une des revendications précédentes, caractérisé par le fait que le circuit est percé d'une ouverture centrale, que le boîtier comporte en outre un pilier central (5), fixé sur l'embase et traversant le circuit par l'ouverture, le capot reposant sur l'embase et le pilier central, et que le circuit reçoit les tensions d'alimentation à sa périphérie et autour de son ouverture.

7. Boîtier selon l'une des revendications précédentes, caractérisé par le fait que l'embase comporte un fond (4), sur lequel est disposé le circuit, et une structure annulaire (2), fixée à la périphérie du fond et supportant le capot.

8. Boîtier selon les revendications 6 et 7, caractérisé par le fait que le fond supporte le pilier central.

9. Boîtier selon l'une des revendications 1 à 4, caractérisé par le fait que le circuit est percé d'une pluralité d'ouvertures (14) et qu'il reçoit les tensions d'alimentation à sa périphérie et autour de ses ouvertures.

10. Boîtier selon l'une des revendications précédentes, caractérisé par le fait que l'embase forme en outre un drain thermique.

11. Boîtier selon l'une des revendications précédentes, caractérisé par le fait qu'il comporte en outre un deuxième circuit (92 ; 97 ; 79 ; 89), disposé sur l'autre face de l'embase, cette dernière étant prévue pour recevoir un deuxième capot, assurant ainsi l'encapsulation du deuxième circuit.

## Claims

1. An encapsulation box containing an electronic circuit, the box comprising a base plate on which is disposed the circuit and a cover for closing the box, the circuit (1; 75) including a plurality of contacts (11, 12; 73, 74), to which the voltages used for its supply are to be fed, these contacts being distributed at the periphery of the circuit and around at least one opening pierced into the latter, and the feed lines of said supply voltages which are disposed between the connection contacts of the box and the respective ones of the circuit comprising each at least one conducting plane (31, 71, 57, 84), the different planes being mounted in a structure of superimposed layers, having no electric contacts with each other, inside the cover (3) and/or the base plate (2, 4; 8).

2. A box according to claim 1, characterized in that said planes further constitute a capacitor.

3. A box according to any one of the preceding claims, characterized in that the electronic circuit is an integrated circuit (1).

4. A box according to any one of the preceding claims, characterized in that the electronic circuit is a hybrid circuit (75).

5. A box according to claim 4, characterized in that the hybrid circuit (75) is decomposed into a plurality of parts (76.1–76.4).

6. A box according to any one of the preceding claims, characterized in that the circuit is pierced by a central opening, that the box comprises in addition a central column (5) mounted on the base plate and traversing the circuit via the opening, the cover resting on the base plate and on the central column, and that the circuit receives the supply voltages at its periphery and around its opening.

7. A box according to one of the preceding claims, characterized in that the base plate comprises a bottom (4) on which the circuit is disposed, and an annular structure (2) fixed to the periphery of the bottom and supporting the cover.

8. A box according to claims 6 and 7, characterized in that the bottom supports the central column.

9. A box according to one of claims 1 to 4, characterized in that the circuit is pierced with a plurality of openings (14) and receives the supply voltages at its periphery and around its openings.

10. A box according to one of the preceding claims, characterized in that the base plate constitutes also a thermal sink.

11. A box according to one of the preceding claims, characterized in that it further includes a second circuit (92; 97; 79; 89) disposed on the other side of the base plate, said plate being provided for receiving a second cover, thus ensuring the encapsulation of the second circuit.

**Patentansprüche**

1. Kapselgehäuse mit einer darin enthaltenen elektronischen Schaltung, wobei das Gehäuse eine Grundplatte, auf der die Schaltung angeordnet ist, und einen Deckel zum Verschließen des Gehäuses aufweist, und die Schaltung (1; 75) eine Vielzahl von Anschlußkontakten (11, 12; 73, 74) besitzt, über die die zu ihrer Versorgung nötigen Spannungen zugeführt werden und die an der Peripherie der Schaltung um mindestens eine in diese gebohrte Öffnung verteilt sind, und wobei die Zuführungspfade der Versorgungsspannungen zwischen den Anschlußkontakten des Gehäuses und denen der Schaltung jeweils mindestens eine leitende Ebene (31, 71, 57, 84) aufweisen, und die verschiedenen Ebenen in übereinander angeordneten Lagen, ohne elektrischen Kontakt miteinander, im Deckel (3) und/oder der Grundplatte (2, 4; 8) angeordnet sind.

2. Gehäuse nach Anspruch 1, dadurch gekennzeichnet, daß die Ebenen weiter einen Kondensator bilden.

3. Gehäuse nach einem der vorhergehenden Ansprüche, dadurch gekennzeichnet, daß die elektronische Schaltung ein integrierter Schaltkreis (1) ist.

4. Gehäuse nach einem der vorhergehenden Ansprüche, dadurch gekennzeichnet, daß die elektronische Schaltung ein Hybrid-Schaltkreis (75) ist.

5. Gehäuse nach Anspruch 4, dadurch gekennzeichnet, daß der Hybrid-Schaltkreis (75) in eine Mehrzahl von Abschnitten (76.1–76.4) unterteilt ist.

6. Gehäuse nach einem der vorhergehenden Ansprüche, dadurch gekennzeichnet, daß die Schaltung mit einer zentralen Öffnung versehen ist, daß das Gehäuse weiter eine zentrale Stütze (5) aufweist, die auf der Grundplatte befestigt ist und die Öffnung der Schaltung durchdringt, wobei der Deckel auf der Grundplatte und der zentralen Stütze ruht, und daß die Schaltung ihre Versorgungsspannungen an ihrer Peripherie und um ihre Öffnung herum erhält.

7. Gehäuse nach einem der vorhergehenden Ansprüche, dadurch gekennzeichnet, daß die Grundplatte einen Boden (4), auf dem die Schaltung angeordnet ist, und eine ringförmige Struktur (2) aufweist, die an der Peripherie des Bodens befestigt ist und den Deckel trägt.

8. Gehäuse nach den Ansprüchen 6 und 7, dadurch gekennzeichnet, daß der Boden die zentrale Stütze trägt.

9. Gehäuse nach einem der Ansprüche 1 bis 4, dadurch gekennzeichnet, daß die Schaltung mit einer Mehrzahl von Öffnungen (14) versehen ist und die Versorgungsspannungen an ihrer Peripherie und um ihre Öffnungen herum zugeführt erhält.

10. Gehäuse nach einem der vorhergehenden Ansprüche, dadurch gekennzeichnet, daß die Grundplatte weiter eine Wärmesenke bildet.

11. Gehäuse nach einem der vorhergehenden Ansprüche, dadurch gekennzeichnet, daß es weiter eine zweite Schaltung (92; 97; 79; 89) aufweist, die auf der anderen Seite der Grundplatte angeordnet ist, wobei letztere zur Aufnahme eines zweiten Deckels geeignet ist, der damit die Kapselung der zweiten Schaltung bewirkt.

FIG.1-a

FIG.1-b

# FIG_2

# FIG_3

# FIG_4

# FIG_5-a

# FIG_5-b

# FIG_6-a

# FIG_6-b

# FIG_7-a

# FIG_7-b

# FIG_9-a

# FIG_9-b

# FIG_8-a

# FIG_8-b